# EUROPEAN PATENT APPLICATION

(11) **EP 4 650 791 A1**
(43) Date of publication of application: **19.11.2025**
(21) Application number: 24175789.7
(22) Date of filing: 14.05.2024
(51) Int. Cl.: G01R 15/20

(54) **ELECTRONIC SYSTEM AND CURRENT SENSING SYSTEM**

(71) Applicant: Monolithic Power Systems, Inc., Kirkland, WA 98033 (US)
(72) Inventor: REYMOND, Serge, Kirkland, 98033 (US); KEJIK, Pavel, Kirkland, 98033 (US)
(74) Representative: Mewburn Ellis LLP

(57) **Abstract**

A current sensing system mounted at a hole located approximately in a busbar center is discussed. The current sensing system has a first sensing point, a second sensing point and an operational amplifier. The first sensing point and the second sensing point are located along a mid-thickness line of the busbar with a substantially equal distance from the mid-wideness line of the busbar.

## Description

### TECHNICAL FIELD

The present invention generally relates to sensor, and more particularly but not exclusively relates to electrical system and current sensing system.

### BACKGROUND OF THE INVENTION

Magnetic sensors are used in various applications. One application that magnetic sensors are used is in the area of current sensors. Sensing current with a magnetic sensor allows to galvanically decouple the primary circuit, i.e. the conductor where the current to be measured flows, from the secondary circuit which carries the measured signal to the electronic control. In the range of 100 amperes and above, the conductor used is often a solid bar of metal with rectangular section, typically copper, often called "busbar". It is widely used for instance in electric vehicles for carrying current to the motor because it optimizes the conductance to weight ratio.

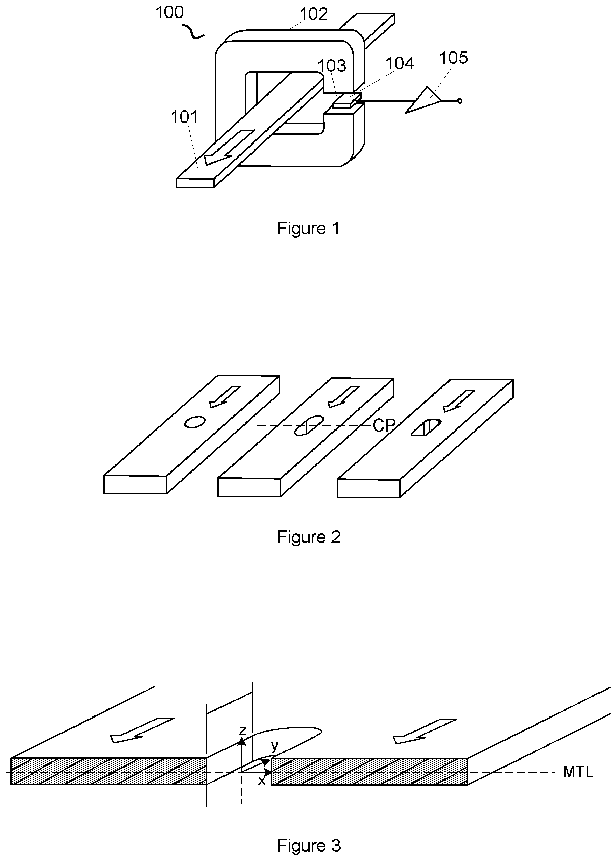

The current flowing through the busbar is usually sensed by a sensor measuring the magnetic field inside the gap of a soft ferromagnetic piece surrounding the conductor. A sensing system 100 equipped with a core is widely used, which is shown in Figure 1. As shown in Figure 1, a busbar 101 carrying current is surrounded by a core 102 having a gap 103. The core 102 concentrates the magnetic field generated by the current flowing through the busbar into the gap 103. A sensor 104 is placed at the gap 103 to measure the magnetic field, thereby to sense the current flowing through the busbar. Then the sensed signal is amplified by an amplifier 105 before being delivered to the electronic control.

However, such core is bulky, resulting in fabrication cost and weight, which is crucial for electric vehicles. In addition, the core limits the bandwidth of the current measurement, and has hysteresis which creates error at low current.

Some prior arts try a coreless solution by setting up a notch in the busbar. But the notch increases the resistance and therefore the Joules heating in the bus bar.

Thus, improvement is needed in a current sensing system.

### BRIEF DESCRIPTION OF THE DRAWINGS

Figure 1 schematically shows a conventional sensing system equipped with a core.
Figure 2 schematically shows busbars carrying a target current in accordance with an embodiment of the present invention.
Figure 3 schematically shows a cross-section view along the CP slice of the busbar in accordance with an embodiment of the present invention.
Figure 4 schematically shows a current sensing system 400 mounted at the hole of the busbar in accordance with an embodiment of the present invention.
Figure 5 schematically shows a current sensing system 500 mounted at the hole of the busbar in accordance with an embodiment of the present invention.
Figure 6 schematically shows magnetic flux lines when the target current is flowing through the busbar during the operation of the system.
Figure 7 schematically shows a current sensing system 700 mounted at the hole of the busbar in accordance with an embodiment of the present invention.
Figure 8 schematically shows an outer package of the sensors when mechanically attached to the busbar in accordance with an embodiment of the present invention.
Figure 9 schematically shows a current sensing system 900 mounted at the hole of the busbar in accordance with an embodiment of the present invention.
Figure 10 schematically shows a current sensing system 1000 mounted at the hole of the busbar in accordance with an embodiment of the present invention.

The use of the similar reference label in different drawings indicates the same of like components.

### SUMMARY OF THE INVENTION

It is an object of the present invention to provide an improved current sensing system, which solves the above problems.

In accomplishing the above and other objects, there has been provided, in accordance with an embodiment of the present invention, an electronic system, comprising: a busbar carrying a current, wherein the busbar has a hole located approximately in a center of the busbar; and a current sensing system mounted at the hole and configured to measure the current flowing through the busbar; wherein the current sensing system includes: a first sensing point (11) mounted at a left side of a mid-wideness line (MWL) which is set as a z axis, wherein the first sensing point (11) is configured to measure a magnetic field generated by the current flowing through the busbar in a z direction; a second sensing point (12) mounted at a right side of the mid-wideness line (MWL), wherein the second sensing point (12) is configured to measure the magnetic field generated by the current flowing through the busbar in the z direction; and an operational amplifier (13) configured to amplify a difference between an output of the first sensing point (11) and an output of the second sensing point (12), to generate an amplified signal (AMP); wherein the mid-wideness line (MWL) comprises a line passing through the center of the busbar along a thickness direction.

In one embodiment, the first sensing point (11) and the second sensing point (12) are located along a mid-thickness line (MTL) with a substantially equal distance from the mid-wideness line (MWL); and wherein the mid-thickness line (MTL) comprises a line passing through the center of the busbar along a width direction and is set as an x axis.

In one embodiment, the first sensing point (11) and the second sensing point (12) are placed away from the mid-thickness line (MTL) respectively with a substantially equal distance (h).

In one embodiment, the x axis and the z axis form a sensing plane.

In one embodiment, a first small core (21), a second small core (22), a third small core (23) and a fourth small core (24), respectively positioned on each corner of the sensing plane.

In one embodiment, the first sensing point (11) and the second sensing point (12) each comprises a half bridge or a single sensor.

In one embodiment, the current sensing system has an outer package cylindrically shaped to substantially fill the hole, with a larger head as stop.

In addition, there has been provided, in accordance with an embodiment of the present invention, a current sensing system configured to be mounted at a hole of a busbar, wherein a coordinate axis system is set with a base point at a cross point of a mid-thickness line (MTL) and a mid-wideness line (MWL), the current sensing system comprising: a first sensing point (11), mounted at a left side of the mid-wideness line (MWL) which is set as a z axis of the coordinate axis system, wherein the first sensing point (11) is configured to measure a magnetic field generated by a current flowing through the busbar in a z direction; a second sensing point (12), mounted at a right side of the mid-wideness line (MWL), wherein the second sensing point (12) is configured to measure the magnetic field generated by the current flowing through the busbar in the z direction; and an operational amplifier (13), configured to amplify a difference between an output of the first sensing point (11) and an output of the second sensing point (12), to generate an amplified signal (AMP); wherein: the first sensing point (11) and the second sensing point (12) are located along the mid-thickness line (MTL) with a substantially equal distance from the mid-wideness line (MWL), and wherein the mid-thickness line (MTL) is set as an x axis of the coordinate axis system.

In one embodiment, the mid-thickness line (MTL) comprises a line passing through the center of the busbar along the width direction; and the mid-wideness line (MWL) comprises a line passing through the center of the busbar along a thickness direction.

In one embodiment, the first sensing point (11) and the second sensing point (12) each comprises a half bridge or a single sensor.

In one embodiment, the first sensing point (11) and the second sensing point (12) are placed away from the mid-thickness line (MTL) respectively with a substantially equal distance.

In one embodiment, the current sensing system has an outer package cylindrically shaped to substantially fill the hole, with a larger head as stop.

In one embodiment, a first small core (21), a second small core (22), a third small core (23) and a fourth small core (24), respectively positioned on each corner of the sensing plane.

Furthermore, there has been provided, in accordance with an embodiment of the present invention, a current sensing system configured to be mounted at a hole located approximately in a center of a busbar, comprising: at least one line of sensors (14), wherein each line has at least two sensors distributed along an x axis and configured to measure a magnetic field generated by a current flowing through the busbar in a z direction; and an operational amplifier (13), configured to amplify a difference between outputs of all the sensors, to generate an amplified signal (AMP); wherein: the x axis comprises a mid-thickness line (MTL) configured to pass through the center of the busbar along a width direction; and the z direction is parallel to an z axis comprising a mid-wideness line (MWL) configured to pass through the center of the busbar along a thickness direction.

In one embodiment, the sensors comprise vertical hall effect sensors, configured to measure an in-plane magnetic field generated by the current flowing through the busbar.

### DETAILED DESCRIPTION

Embodiments of circuits for current sensing system are described in detail herein. In the following description, some specific details, such as example circuits for these circuit components, are included to provide a thorough understanding of embodiments of the invention. One skilled in relevant art will recognize, however, that the invention can be practiced without one or more specific details, or with other methods, components, materials, etc.

The following embodiments and aspects are illustrated in conjunction with circuits and methods that are meant to be exemplary and illustrative. In various embodiments, the above problem has been reduced or eliminated, while other embodiments are directed to other improvements.

Figure 2 schematically shows busbars carrying a target current in accordance with an embodiment of the present invention. The target current is the current that needs to be measured and delivered to post stages to have further electric control. As shown in Figure 2, a through hole is located approximately in the center of the busbar along the width direction. The busbar comprises a conductor carrying the target current, typically has a relatively high current value, e.g., tens of amperes. In one embodiment of the present invention, the busbar is made of copper.

The hole may be a circular, slotted, or rectangular. In one embodiment of the present invention, the hole shape and size depend on the easiness of manufacture, the amplitude of the signal and the allowed variation due to misalignment. A current sensor may be mounted at the hole with appropriate setting, which will be illustrated in detail in the following description with a cross-section view along the CP slice.

Figure 3 schematically shows a cross-section view along the CP slice of the busbar in accordance with an embodiment of the present invention. As shown in Figure 3, a coordinate axis system is set, with a base point at a cross point of a mid-thickness line MTL and a mid-wideness line MWL. The mid-thickness line MTL comprises a line passing through the busbar center along the width direction, which is set as the x axis of the coordinate axis system. The mid-wideness line comprises a line passing through the hole center along the thickness direction, which is set as the z axis of the coordinate axis system. In one embodiment of the present invention, the y axis is along the length of the busbar (i.e. along the length of the hole).

In one embodiment of the present invention, the x-z plane is the sensing plane. The x axis is parallel to a x direction; and the z axis is parallel to a z direction.

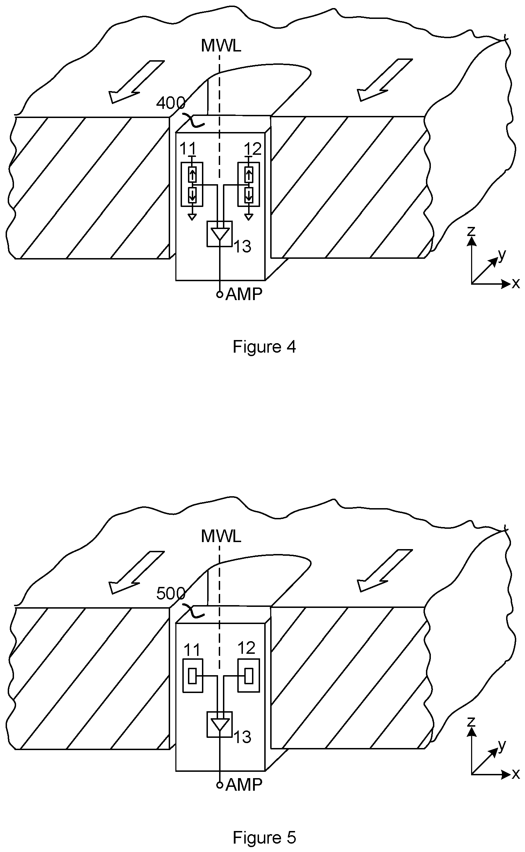

Figure 4 schematically shows a current sensing system 400 mounted at the hole of the busbar in accordance with an embodiment of the present invention. In the example of Figure 4, the current sensing system comprises: a first sensing point 11, mounted at a left side of the mid-wideness line MWL; a second sensing point 12, mounted at a right side of the mid-wideness line MWL; and an operational amplifier (also called as a differential difference amplifier) 13. The first sensing point 11 and the second sensing point 12 are located along the x direction with a substantially equal distance (e.g. respectively with +r and -r as shown in Figure 4) from the mid-wideness line MWL.

The first sensing point 11 and the second sensing point 12 respectively measures the magnetic field generated by the target current flowing through the busbar in the z direction. Then the outputs of the first sensing point 11 and the second sensing point 12 are delivered to the operational amplifier 13. The operational amplifier 13 is operable to amplify the difference between the outputs of the first sensing point 11 and the second sensing point 12, to generate an amplified signal AMP.

In one embodiment of the present invention, each of the first sensing point 11 and the second sensing point 12 may comprise a half bridge, e.g., two sensors coupled in series between a power supply and a reference ground, as shown in Figure 4. In another embodiment of the present invention, the first sensing point 11 and the second sensing point 12 may each comprise a single sensor, as shown in Figure 5. The sensor may comprise a linear sensor, with sensitivity direction along the z direction. The linear sensor may comprise vertical hall effect sensor with measure field in the sensor plane or tunneling magneto resistance (TMR) sensor which also measures the in-plane field. If the application has a low noise requirement, the TMR sensor may be preferred.

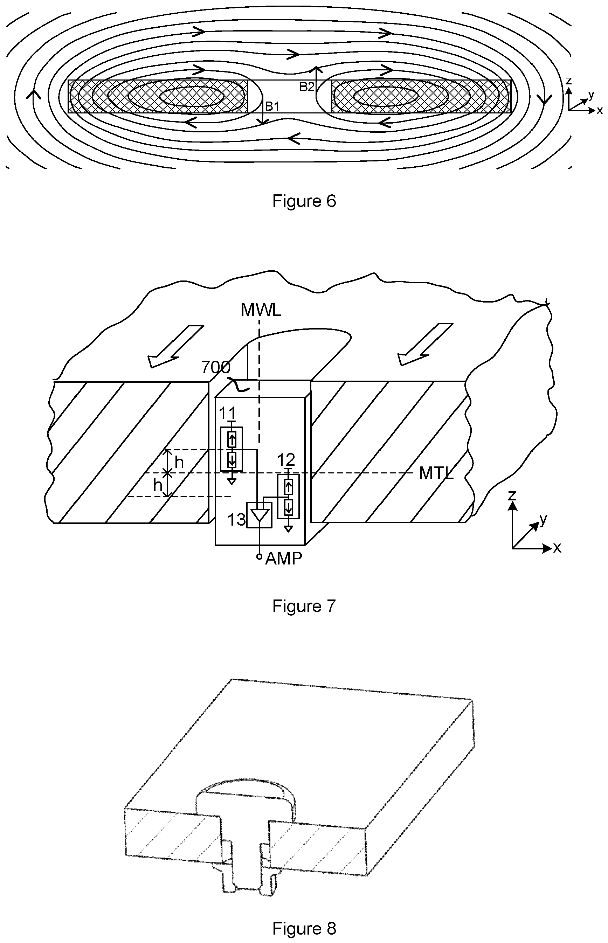

Figure 6 schematically shows magnetic flux lines when the target current is flowing through the busbar during the operation of the system. The space inside the hole can be deemed as the empty space between two nearby busbars. Therefore, the magnetic flux lines change direction in the center point of the hole in the z direction. As shown in Figure 6, one direction is downwards, which is shown as B1, while the other direction is upwards, which is shown as B2.

Because the distance between the two sensing points is much larger than the distance between any sensing point (11 or 12) and a neighbor conductor carrying current, the magnetic field generated by the neighbor conductor is almost the same at the two sensing points, and therefore is essentially considered as uniform. A uniform magnetic field creates a same contribution on the two sensing points. Since the output of the operational amplifier 13 is the difference between the outputs of the first sensing point 11 and the second sensing point 12, the uniform external magnetic field is cancelled and does not contribute to the output of the operational amplifier 13.

Regarding the magnetic field generated by the target current flowing through the busbar, because the first sensing point 11 and the second sensing point 12 are located along the x direction with a substantially equal distance from the mid-wideness line MWL, the effects of the magnetic field to the first sensing point 11 and the second half bridge 12 along the x direction are counteracted. Similarly, the effects of the magnetic field to the first sensing point 11 and the second half bridge 12 along the y direction are counteracted, too. However, because the magnetic fields along the z direction are opposite to each other, the effects of the magnetic field to the first sensing point 11 and the second sensing point 12 along the z direction are also opposite to each other. Thus, the amplified signal AMP which indicates the difference between the outputs of the first sensing point 11 and the second sensing point 12 is proportional to the target current flowing through the busbar.

Thus, the current sensing system 400 and/or 500 effectively measures the current in close vicinity to the hole; and the output of the operational amplifier (i.e. the output of the current sensing system) is essentially proportional to the current density.

Thus, by appropriately setting a hole in the busbar, and appropriately locating the sensors, the current flowing in the busbar is well measured without a bulky core.

In one embodiment of the present invention, the current sensing system may be mechanically attached to the busbar, or may be not mechanically attached to the busbar, e.g., the sensors may be directly mounted on a printed circuit board controlling the power for instance, for an electric motor, in some applications. In the circumstances that the sensors are not mechanically attached to the busbar, the position of the two sensing points may vary with respect to the busbar because there may be relative vibrations between the busbar and the printed circuit board. The effect of such misplacement may be reduced by having the two sensing points placed away from the busbar mid-thickness line, as shown below in Figure 7.

Figure 7 schematically shows a current sensing system 700 mounted at the hole of the busbar in accordance with an embodiment of the present invention. The current sensing system 700 in Figure 7 is similar to the current sensing system 400 in Figure 4, with a difference that in the example of Figure 7, the first sensing point 11 and the second sensing point 12 are placed away from the mid-thickness line MTL respectively with a substantially equal distance h.

In the z direction, because the magnetic field is maximum at the mid-thickness line, a motion of the sensors along the z direction would have the magnetic field increased at one sensing point and decreased at the other one. Thus, the first order gain variation is cancelled.

In the circumstances that the current sensing system are mechanically attached to the busbar. The current sensing system may have an outer package (or a "probe") cylindrically shaped to substantially fill the hole, with a larger head as stop, like a screw, which is shown in Figure 8. It may be threaded on the opposite end to be firmly tightened against the busbar. In one embodiment of the present invention, the outer package of the sensors may be equipped with a side pin to guarantee the alignment of the sensors inside the hole with respect to the current flow direction. Such output package prevents the sensors to have any relative motion with respect to the busbar, which ensures the amplified signal AMP to have no change during the product usage. In another embodiment of the present invention, the probe is inserted into the hole and then over-molded, together with a connector, to make a busbar current sensor module.

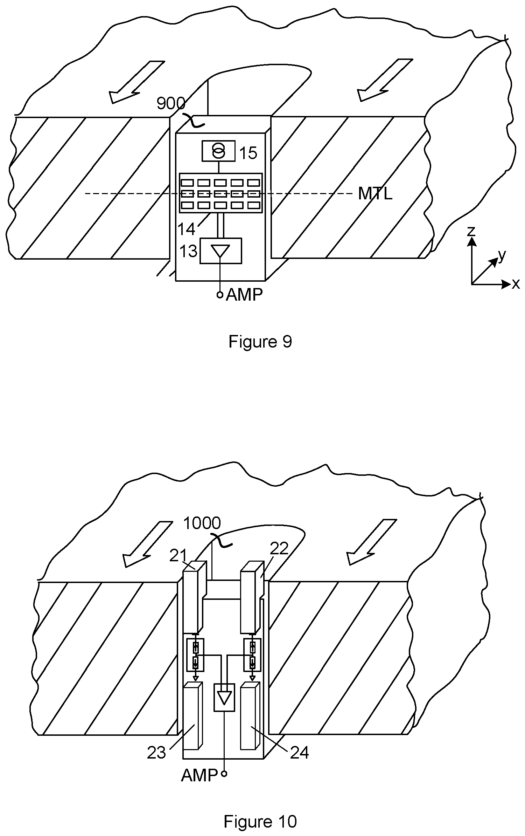

Figure 9 schematically shows a current sensing system 900 mounted at the hole of the busbar in accordance with an embodiment of the present invention. In the example of Figure 9, the current sensing system 900 comprises: at least one line of sensors 14, wherein each line has at least two sensors distributed along the x axis. The sensors are configured to measure a magnetic field generated by the current flowing through the busbar in the z direction. The current sensing system 900 further comprises an operational amplifier 13, configured to amplify the difference between the outputs of all the sensors, to generate an amplified signal AMP.

In one embodiment of the present invention, all the sensors are integrated on a same die.

In the example of Figure 9, three lines are shown. However, one skilled in the art should realize that any desired number lines is appropriate, to measure the magnetic field along the z axis, and to compensate the misalignments along the z axis.

In one embodiment of the present invention, the lines of sensors are located centered with respect to the mid-thickness line MTL.

In one embodiment of the present invention, the sensors comprise vertical hall effect sensors, configured to measure an in-plane magnetic field generated by the current flowing through the busbar. The current sensing system 900 further comprises: a hall bias current block 15, configured to provide bias current to the sensors, so that the vertical hall effect sensors are appropriately biased and generate desired signals to the operational amplifier 13.

Figure 10 schematically shows a current sensing system 1000 mounted at the hole of the busbar in accordance with an embodiment of the present invention. The current sensing system 1000 in Figure 10 is similar to the current sensing system 400 in Figure 4, with a difference that in the example of Figure 10, the current sensing system 1000 further comprises: a first small core (21), a second small core (22), a third small core (23) and a fourth small core (24), respectively positioned on each corner of the sensing plane, to concentrate the magnetic flux into the sensing plane.

In one embodiment of the present invention, the cores may be made of soft ferromagnetic material with high magnetic permeability.

It is to be understood in these letters patent that the meaning of "A" is coupled to "B" is that either A and B are connected to each other as described below, or that, although A and B may not be connected to each other as described above, there is nevertheless a device or circuit that is connected to both A and B. This device or circuit may include active or passive circuit elements, where the passive circuit elements may be distributed or lumped-parameter in nature. For example, A may be connected to a circuit element that in turn is connected to B.

This written description uses examples to disclose the invention, including the best mode, and also to enable a person skilled in the art to make and use the invention. The patentable scope of the invention may include other examples that occur to those skilled in the art.

## Claims

1. An electronic system, comprising:
a busbar carrying a current, wherein the busbar has a hole located approximately in a center of the busbar; and
a current sensing system mounted at the hole and configured to measure the current flowing through the busbar;
wherein the current sensing system includes:
a first sensing point (11) mounted at a left side of a mid-wideness line (MWL) which is set as a z axis, wherein the first sensing point (11) is configured to measure a magnetic field generated by the current flowing through the busbar in a z direction;
a second sensing point (12) mounted at a right side of the mid-wideness line (MWL), wherein the second sensing point (12) is configured to measure the magnetic field generated by the current flowing through the busbar in the z direction; and
an operational amplifier (13) configured to amplify a difference between an output of the first sensing point (11) and an output of the second sensing point (12), to generate an amplified signal (AMP); wherein
the mid-wideness line (MWL) comprises a line passing through the center of the busbar along a thickness direction.

2. The electronic system of claim 1, wherein:
the first sensing point (11) and the second sensing point (12) are located along a mid-thickness line (MTL) with a substantially equal distance from the mid-wideness line (MWL); and wherein
the mid-thickness line (MTL) comprises a line passing through the center of the busbar along a width direction and is set as an x axis.

3. The electronic system of claim 2, wherein:
the first sensing point (11) and the second sensing point (12) are placed away from the mid-thickness line (MTL) respectively with a substantially equal distance (h).

4. The electronic system of claim 2, wherein:
the x axis and the z axis form a sensing plane.

5. The electronic system of claim 4, further comprising:
a first small core (21), a second small core (22), a third small core (23) and a fourth small core (24), respectively positioned on each corner of the sensing plane.

6. The electronic system of claim 1, wherein:
the first sensing point (11) and the second sensing point (12) each comprises a half bridge or a single sensor.

7. The electronic system of claim 1, wherein:
the current sensing system has an outer package cylindrically shaped to substantially fill the hole, with a larger head as stop.

8. A current sensing system configured to be mounted at a hole of a busbar, wherein a coordinate axis system is set with a base point at a cross point of a mid-thickness line (MTL) and a mid-wideness line (MWL), the current sensing system comprising:
a first sensing point (11), mounted at a left side of the mid-wideness line (MWL) which is set as a z axis of the coordinate axis system, wherein the first sensing point (11) is configured to measure a magnetic field generated by a current flowing through the busbar in a z direction;
a second sensing point (12), mounted at a right side of the mid-wideness line (MWL), wherein the second sensing point (12) is configured to measure the magnetic field generated by the current flowing through the busbar in the z direction; and
an operational amplifier (13), configured to amplify a difference between an output of the first sensing point (11) and an output of the second sensing point (12), to generate an amplified signal (AMP); wherein:
the first sensing point (11) and the second sensing point (12) are located along the mid-thickness line (MTL) with a substantially equal distance from the mid-wideness line (MWL), and wherein the mid-thickness line (MTL) is set as an x axis of the coordinate axis system.

9. The current sensing system of claim 8, wherein:
the mid-thickness line (MTL) comprises a line passing through the center of the busbar along the width direction; and
the mid-wideness line (MWL) comprises a line passing through the center of the busbar along a thickness direction.

10. The current sensing system of claim 8, wherein:
the first sensing point (11) and the second sensing point (12) each comprises a half bridge or a single sensor.

11. The current sensing system of claim 8, wherein:
the first sensing point (11) and the second sensing point (12) are placed away from the mid-thickness line (MTL) respectively with a substantially equal distance.

12. The current sensing system of claim 8, wherein:
the current sensing system has an outer package cylindrically shaped to substantially fill the hole, with a larger head as stop.

13. The current sensing system of claim 8, further comprising:
a first small core (21), a second small core (22), a third small core (23) and a fourth small core (24), respectively positioned on each corner of the sensing plane.

14. A current sensing system configured to be mounted at a hole located approximately in a center of a busbar, comprising:
at least one line of sensors (14), wherein each line has at least two sensors distributed along an x axis and configured to measure a magnetic field generated by a current flowing through the busbar in a z direction; and
an operational amplifier (13), configured to amplify a difference between outputs of all the sensors, to generate an amplified signal (AMP); wherein:
the x axis comprises a mid-thickness line (MTL) configured to pass through the center of the busbar along a width direction; and the z direction is parallel to an z axis comprising a mid-wideness line (MWL) configured to pass through the center of the busbar along a thickness direction.

15. The current sensing system of claim 14, wherein:
the sensors comprise vertical hall effect sensors, configured to measure an in-plane magnetic field generated by the current flowing through the busbar.
